# EUROPEAN PATENT APPLICATION

(11) **EP 4 340 050 A1**
(43) Date of publication of application: **20.03.2024**
(21) Application number: 22807826.7
(22) Date of filing: 11.05.2022
(51) Int. Cl.: H01L 33/24, H01L 33/12, H01L 33/06, H01L 33/30, H01L 33/32, H01L 33/50, H01L 33/18

(54) **MULTI-BAND LIGHT EMITTING DIODE**

(30) Priority: 11.05.2021 US 202163187132 P; 11.05.2021 US 202163187158 P; 22.04.2022 US 202263333602 P; 10.05.2022 US 202217740856
(71) Applicant: Seoul Viosys Co., Ltd., Ansan-si, Gyeonggi-do 15429 (KR)
(72) Inventor: MIN, Dae Hong, Ansan-si Gyeonggi-do 15429 (KR); BAEK, Yong Hyun, Ansan-si Gyeonggi-do 15429 (KR); KANG, Ji Hun, Ansan-si Gyeonggi-do 15429 (KR)
(74) Representative: Isarpatent
(86) International application number: PCT/KR2022/006730
(87) International publication number: WO 2022/240179

(57) **Abstract**

A light emitting diode according to an embodiment disclosed herein includes: a first conductive nitride semiconductor layer; a V-pit generation layer disposed on the first conductive nitride semiconductor layer and having V-pits; an active layer disposed on the V-pit generation layer; a stress relaxation layer disposed between the V-pit generation layer and the active layer; and a second conductive nitride semiconductor layer disposed on the active layer. The stress relaxation layer and the active layer may be formed inside the V-pits in addition to being formed on flat surfaces of the V-pit generation layer, and the active layer may emit light having a multi-band spectrum.

## Description

### [Technical Field]

The present disclosure relates to a light emitting diode, and more particularly, to a light emitting diode emitting light of a plurality of bands at a single chip level.

### [Background Art]

A nitride semiconductor is used as a light source of a display apparatus, traffic light, lighting, or an optical communication device, and is mainly used in a light emitting diode or a laser diode that emits blue or green light. In addition, the nitride semiconductor may be used in a heterojunction bipolar transistor (HBT), a high electron mobility transistor (HEMT), and the like.

In general, a light emitting diode using the nitride semiconductor has a heterojunction structure having a quantum well structure between an N contact layer and a P contact layer. The light emitting diode emits light according to a composition of a well layer in the quantum well structure. In order to increase an internal quantum efficiency and reduce the loss due to light absorption, the light emitting diode is designed to emit light of a spectrum having a single peak, that is, monochromatic light.

Mixed color light, such as white light, emitted from lighting or the like cannot be implemented as single-peak monochromatic light. Accordingly, a technique of implementing white light by using a plurality of light emitting diodes together emitting different monochromatic light from each other or by using phosphor converting a wavelength of light emitted from the light emitting diode is generally used.

The use of phosphors is accompanied by a drawback such as a cost of the phosphors themselves or a decrease in efficiency known as Stoke's shift. In addition, it is accompanied by a drawback such as a process of applying phosphors on the light emitting diode and yellowing of a carrier carrying phosphors.

Moreover, using a mixture of a plurality of light emitting diodes also complicates the process, and it is inconvenient to prepare the light emitting diodes made of different materials from one another.

Accordingly, a research on a light emitting diode that emits light of a plurality of bands at a single chip level has been conducted. When the light emitting diode emitting light of the plurality of bands at the single chip level is used, there is no need to use a plurality of light emitting diodes made of different materials, and the use of phosphors can be eliminated or at least reduced.

However, V-pits are used so as to manufacture multi-band light emitting diodes, and due to a stress in epitaxial layers according to the V-pit generation, a sharp decrease in an external quantum efficiency according to an increase in current density, that is, a droop phenomenon, occurs severely.

In addition, white light can be implemented using mixed color light emitted from the multi-band light emitting diode, but it is necessary to relatively improve CRI (Color Rendering Index) compared to that of white light using a conventional blue light emitting device and a phosphor.

### [DISCLOSURE]

### [Technical Problem]

Exemplary embodiments of the present disclosure provide a multi-band light emitting diode having a high external quantum efficiency (EQE) in a wide current density range.

Exemplary embodiments of the present disclosure provide a multi-band light emitting diode implementing white light with high color rendering index.

### [Technical Solution]

A light emitting diode according to an exemplary embodiment of the present disclosure includes a first conductivity type nitride semiconductor layer, a V-pit generation layer disposed on the first conductivity type nitride semiconductor layer and having V-pits, an active layer disposed on the V-pit generation layer, a stress relief layer disposed between the V-pit generation layer and the active layer, and a second conductivity type nitride semiconductor layer disposed on the active layer. The stress relief layer and the active layer may be formed in the V-pit, as well as on a flat surface of the V-pit generation layer, and the active layer may emit light of a multi-band spectrum.

The stress relief layer may be a superlattice layer.

The stress relief layer may have a structure where first and second layers are alternately stacked, in which an energy band gap of the first layer may be smaller than that of the second layer, and a lattice constant of the first layer may be greater than that of the V-pit generation layer and smaller than that of a well layer of the active layer.

The light emitting diode may further include a gap layer between the stress relief layer and the active layer, and the gap layer may have a lattice constant smaller than an average lattice constant of the stress relief layer.

The light emitting diode may further include an intermediate layer disposed between the stress relief layer and the active layer, a first gap layer disposed between the intermediate layer and the active layer, and a second gap layer disposed between the intermediate layer and the stress relief layer, in which the first and second gap layers may have lattice constants smaller than an average lattice constant of the stress relief layer, and the intermediate layer may have a lattice constant greater than the average lattice constant of the stress relief layer.

The stress relief layer may have a structure where first and second layers are alternately stacked, an energy band gap of the first layer may be smaller than that of the second layer, and a lattice constant of the first layer may be greater than that of the V-pit generation layer and smaller than that of a well layer of the active layer.

The first layer of the stress relief layer, the intermediate layer, and the well layer of the active layer may be nitride semiconductor layers containing In, in which the first layer may contain a least In, and the well layer of the active layer may contain a most In among the first layer of the stress relief layer, the intermediate layer, and the well layer of the active layer.

A content of In contained in the intermediate layer may be closer to a content of In contained in the first layer than a content of In contained in the well layer of the active layer.

The light emitting diode may further include a wavelength conversion material disposed on the second conductivity type nitride semiconductor layer, in which the second conductivity type nitride semiconductor layer may have a concave groove on a surface thereof, and the wavelength conversion material may be disposed in the concave groove.

The wavelength conversion material may include quantum dots emitting red light.

The light emitting diode according to an exemplary embodiment of the present disclosure may maintain an external quantum efficiency of 80% or more compared to a maximum external quantum efficiency over a current density range of at least 50 A/cm² or more.

The light emitting diode may include a substrate and a nitride semiconductor layer grown on the substrate, in which the substrate may have a c-.growth plane, and the nitride semiconductor layer may be grown on the c-growth plane of the substrate.

The light emitting diode may maintain an external quantum efficiency of 80% or more compared to a maximum external quantum efficiency over a current density range of 100 A/cm² or more.

The light emitting diode may maintain an external quantum efficiency of 80% or more compared to a maximum external quantum efficiency over a current density range of 120 A/cm² or more.

The light emitting diode may maintain an external quantum efficiency of 60% or more compared to a maximum external quantum efficiency over a current density range of 100 A/cm² or more.

The light emitting diode may emit white light having a different color temperature depending on a current density, and may emit white light having a higher color temperature at a higher current density.

The light emitting diode may include a first conductivity type nitride semiconductor layer, a V-pit generation layer disposed on the first conductivity type nitride semiconductor layer and having V-pits, an active layer disposed on the V-pit generation layer, a stress relief layer disposed between the V-pit generation layer and the active layer, and a second conductivity type nitride semiconductor layer disposed on the active layer, in which the active layer may emit light of a multi-band spectrum.

The light emitting diode may further include an intermediate layer disposed between the stress relief layer and the active layer, a first gap layer disposed between the intermediate layer and the active layer, and a second gap layer disposed between the intermediate layer and the stress relief layer, in which the intermediate layer may have a lattice constant smaller than an average lattice constant of the stress relief layer.

The light emitting diode may further include a substrate, in which the substrate may have a c-growth plane, and the first conductivity type nitride semiconductor layer may be grown on the c-growth plane of the substrate.

The light emitting diode may further include a wavelength conversion material disposed on the second conductivity type nitride semiconductor layer, in which the second conductivity type nitride semiconductor layer may have a concave groove on a surface thereof, and the wavelength conversion material may be disposed in the concave groove.

### [Description of Drawings]

FIG. 1 is a schematic cross-sectional view illustrating a light emitting diode according to an exemplary embodiment of the present disclosure.
FIG. 2 is a schematic cross-sectional view illustrating a light emitting diode according to another exemplary embodiment of the present disclosure.
FIG. 3 is a TEM image of a region A of FIG. 2.
FIG. 4A and FIG. 4B are band diagrams of a stacked structure in L1 and L2 directions of FIG. 2, respectively.
FIG. 5 is an atomic probe tomography (APT) graph for the stacked structure in the L1 direction of FIG. 2.
FIG. 6 is a graph showing external quantum efficiency droops (EQE droop) of Comparative Example, Inventive Examples 1 and 2.
FIG. 7 is a graph showing electroluminescence (EL) spectra of Comparative Example, Inventive Examples 1 and 2.
FIG. 8 is a schematic cross-sectional view illustrating a light emitting diode according to another exemplary embodiment of the present disclosure.
FIG. 9 is a TEM image showing a shape of a surface groove of a light emitting diode.
FIG. 10 is a schematic cross-sectional view illustrating a light emitting diode according to another exemplary embodiment of the present disclosure.

### [Detailed Description of the Illustrated Embodiments]

Hereinafter, exemplary embodiments will be described in detail with reference to the accompanying drawings. The following exemplary embodiments are provided by way of example so as to fully convey the spirit of the present disclosure to those skilled in the art to which the present disclosure pertains. Accordingly, the present disclosure should not be limited to the specific disclosed forms, and be construed to include all modifications, equivalents, or replacements included in the spirit and scope of the present disclosure. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

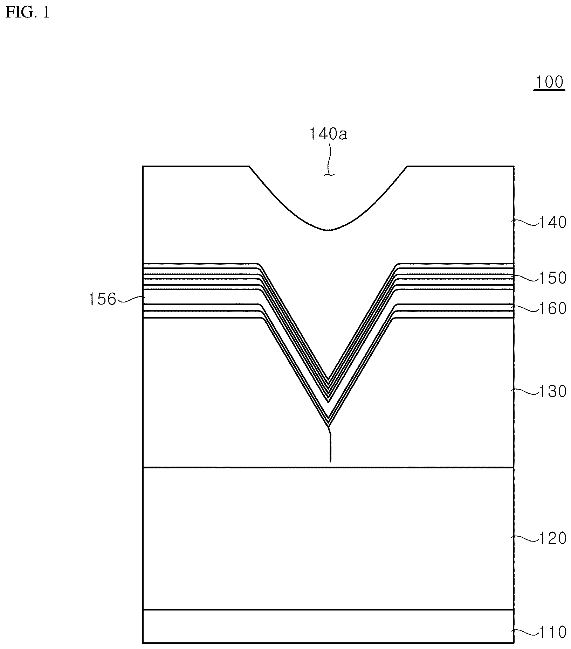

FIG. 1 is a schematic cross-sectional view illustrating a light emitting diode according to an exemplary embodiment of the present disclosure.

Referring to FIG. 1, a light emitting diode 100 may include a substrate 110, a first conductivity type nitride semiconductor layer 120, a V-pit generation layer 130, a stress relief layer 160, a gap layer 156, an active layer 150, and a second conductivity type nitride semiconductor layer 140.

The substrate 110 is for growing a gallium nitride-based semiconductor layer, and may include a sapphire substrate, a GaN substrate, a SiC substrate, a Si substrate, a spinel substrate, and the like. The substrate 110 may have protrusions, and may be, for example, a patterned sapphire substrate. However, the inventive concepts are not limited thereto, and may be a substrate having a flat upper surface, for example, a sapphire substrate.

The first conductivity type nitride semiconductor layer 120 may be, for example, a nitride-based semiconductor layer doped with an n-type impurity, and may be formed of, for example, a GaN layer doped with Si. For example, a Si doping concentration doped into the first conductivity type nitride semiconductor layer 120 may be 5E17/cm³ to 5E19/cm³. The n-type nitride semiconductor layer may be grown under a growth pressure of 150 Torr to 200 Torr at 1000 °C to 1200 °C (e.g., 1050 °C to 1100 °C) by supplying a metal source gas into a chamber using MOCVD technology. To grow the first conductivity type nitride semiconductor layer 120, a nucleation layer and a high-temperature buffer layer may be additionally formed. That is, the nucleation layer, the high-temperature buffer layer, and the first conductivity type nitride semiconductor layer 120 may be continuously formed on the substrate 110. A large number of threading dislocations may be formed in the high-temperature buffer layer, and at least portions of the threading dislocations in the high-temperature buffer layer may be transferred to the first conductivity type nitride semiconductor layer 120.

The V-pit generation layer 130 is disposed over the first conductivity type nitride semiconductor layer 120. In an exemplary embodiment of the present disclosure, the V-pit generation layer 130 may be formed of, for example, a GaN layer. The V-pit generation layer 130 may be grown at a relatively lower temperature than that for growing the first conductivity type nitride semiconductor layer 120, for example, about 900 °C, and thus, V-pits may be formed in the V-pit generation layer 130.

By growing the V-pit generation layer 130 at a temperature relatively lower than that for growing the first conductivity type nitride semiconductor layer 120, a crystal quality may be artificially deteriorated and a three-dimensional growth may be promoted to generate the V-pits.

The V-pits may have a hexagonal pyramid shape when a growth plane of the nitride semiconductor layer is a c-plane. Each V-pit may be formed at an upper end of the threading dislocation.

The V-pit generation layer 130 may be formed to have a thickness smaller than that of the first conductivity type nitride semiconductor layer 120, for example, to have a thickness of about 450 nm to 600 nm. Sizes of the V-pits formed in the V-pit generation layer 130 may be adjusted through a growth condition and a growth time of the V-pit generation layer 130. In an exemplary embodiment, a maximum width of an inlet of the V-pit formed in the V-pit generation layer 130 may generally exceed about 200 nm.

The thickness of the V-pit generation layer 130 particularly affects the size of the V-pit. Moreover, the size of the V-pit is considered to play a major role in generating light having a multi-band spectrum.

In the illustrated exemplary embodiment, the V-pit generation layer 130 is described as a single layer, without being limited thereto, or may be a multi-layer. For example, the V-pit generation layer 130 may include at least two layers among GaN, AlGaN, InGaN, or AlGaInN layers.

The stress relief layer 160 is disposed on the V-pit generation layer 130. The stress relief layer 160 may be grown along a shape of the V-pit formed in the V-pit generation layer 130. In addition, the stress relief layer 160 may function to relieve a strain formed when the nitride semiconductor layer is grown so as to increase a radiation efficiency of the active layer 150 formed thereon, and may include a nitride semiconductor layer such as InₓAl_{y}Ga_{1-x-y}N (0<x<1, 0≤y<1).

The stress relief layer 160 may include a plurality of nitride semiconductor layers, and may include, for example, a superlattice layer formed by alternately stacking materials having different energy band gaps multiple times. For example, in the stress relief layer 160, a first layer having a smaller band gap and a second layer having a larger band gap may be alternately stacked. A thickness of the first layer having the smaller band gap may be smaller than that of the second layer having the larger band gap, and further, the thickness of the first layer may be smaller than that of a well layer of the active layer 150. The thickness of the second layer may be smaller than that of a barrier layer of the active layer 150. The thickness of the first layer may be 5 nm or less, further, 3 nm or less, and may be 2 nm or more. The thickness of the second layer may be 5 nm or less, further, 4 nm or less, 2 nm or more, further 3 nm or more.

An average lattice constant of the stress relief layer 160 may be greater than that of the V-pit generation layer 130 or the first conductivity type nitride semiconductor layer 120, and may be smaller than that of the active layer 150. In an exemplary embodiment, the lattice constant of the first layer may be smaller than that of the well layer of the active layer 150. For example, a composition ratio of Indium (In) of the first layer may be smaller than that of the well layer.

The stress relief layer 160 may relieve a stress between the first conductivity type nitride semiconductor layer 120 and the active layer 150, improve a film quality of the active layer 150, and increase a flow rate of carriers to improve the radiation efficiency. The stress relief layer 160 may be doped with an impurity like the first conductivity type semiconductor layer 120.

The gap layer 156 is disposed between the active layer 150 and the stress relief layer 160. A lattice constant of the gap layer 156 may be smaller than the average lattice constant of the stress relief layer 160, and may be smaller than the average lattice constant of the active layer 150. The gap layer 156 may be the barrier layer of the active layer 150 or any layer in the stress relief layer 160, for example, a nitride-based semiconductor layer having a same composition as the second layer, without being limited thereto. The gap layer 156 may be, for example, a GaN layer. A thickness of the gap layer 156 may be greater than that of the barrier layer in the active layer 150, without being limited thereto. The gap layer 156 may be grown along a shape of the stress relief layer 160.

The active layer 150 may include a well layer and a barrier layer, and may include a plurality of well layers and a plurality of barrier layers. The active layer 150 may be in contact with the stress relief layer, but the inventive concepts are not limited thereto. The active layer 150 may be formed along the shape of the V-pit. A thickness of the active layer formed in the V-pit is smaller than that of the active layer 150 formed on a flat surface of the V-pit generation layer 130. The thickness of the active layer 150 in the V-pit may vary depending on a depth of the V-pit. The thickness of the active layer 150 at an approximately intermediate depth of the V-pit may be about 1/3 or less of the thickness of the active layer 150 formed on the flat surface of the V-pit generation layer 130. In particular, a thickness of the well layer in the active layer 150 at the approximately intermediate depth of the V-pit may be about 1/3 or less of a thickness of the well layer formed on the flat surface of the V-pit generation layer 130.

Meanwhile, the well layer may be formed of InₓAl_{y}Ga_{1-xy}N (0<x<1, 0≤y<1). Composition ratios of In, Al, and Ga may be selected depending on a required light. In particular, the well layer formed on the flat surface of the V-pit generation layer 130 (hereinafter, the well layer of a first region) has a composition for emitting light having a longer wavelength spectrum of multi-bands. Meanwhile, the well layer formed in the V-pit (hereinafter, the well layer of a second region) has a composition for emitting light having a shorter wavelength spectrum of multi-bands. For example, a ratio of Indium (In) composition in the well layer of the first region may be higher than that of In composition in the well layer of the second region, the well layer of the first region may be formed of InGaN having a composition emitting yellow light, and the well layer of the second region may be formed of InGaN having a composition emitting green and/or blue light.

The well layer of the second region may be formed on each surface in the V-pit with a same composition, without being limited thereto, or may be formed on each surface with a different composition. Accordingly, the light emitting diode 100 of the present disclosure may implement light having at least two bands at a single chip level using the well layer of the first region and the well layer of the second region.

The barrier layer in the active layer 150 may be formed of a nitride semiconductor layer such as GaN, InGaN, AlGaN, AlInGaN, or the like, which has a wider band gap than the well layer. For example, when the well layer of the first region is formed of InGaN so as to emit yellow light, the barrier layer may be formed of InGaN having a lower content of In than the well layer.

A capping layer (not shown) may further be included between the well layer and the barrier layer. The capping layer may be formed before depositing the barrier layer so as to prevent dissociation of In in the well layer while the barrier layer is deposited.

The second conductivity type nitride semiconductor layer 140 is disposed on the active layer 150. The second conductivity type nitride semiconductor layer 140 may be formed as a single layer, without being limited thereto. The second conductivity type nitride semiconductor layer 140 may include a current blocking layer and a contact layer, and the current blocking layer may be disposed between the contact layer and the active layer 150. For example, the current blocking layer may include a p-type AlₓGa₁₋ₓN layer.

The contact layer of the second conductivity type nitride semiconductor layer 140 may include a semiconductor layer doped with a p-type impurity such as Mg, for example, a GaN layer. The second conductivity type nitride semiconductor layer 140 may further include an additional layer between the contact layer and the current blocking layer.

As shown in FIG. 1, the second conductivity type nitride semiconductor layer 140 may have a concave groove 140a over the V-pit. Since the second conductivity type nitride semiconductor layer 140 has the concave groove 140a, it is possible to reduce loss of light generated from the active layer 150 in the V-pit by the second conductivity type nitride semiconductor layer 140.

According to the illustrated exemplary embodiment, by disposing the stress relief layer 160 between the V-pit generation layer 130 and the active layer 150, it is possible to reduce a stress in the active layer 150, and improve a crystal quality of the active layer 150. Accordingly, droop of the light emitting diode may be alleviated.

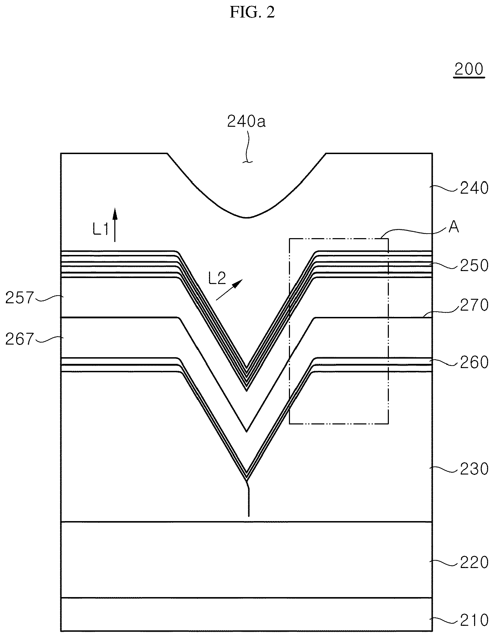

FIG. 2 is a schematic cross-sectional view illustrating a light emitting diode 200 according to another exemplary embodiment of the present disclosure.

Referring to FIG. 2, the light emitting diode 200 may include a substrate 210, a second conductivity type nitride semiconductor layer 220, a V-pit generation layer 230, a stress relief layer 260, an intermediate layer 270, and first and second gap layers 257 and 267, an active layer 250, and a second conductivity type nitride semiconductor layer 240. In addition, the second conductivity type nitride semiconductor layer 240 may include a concave groove 240a on an upper surface thereof.

The light emitting diode 200 according to the illustrated exemplary embodiment is substantially similar to the light emitting diode 100 described with reference to FIG. 1, except that the first and second gap layers 257 and 267 and the intermediate layer 270 are interposed between the stress relief layer 260 and the active layer 240. In particular, since the substrate 210, the first conductivity type semiconductor layer 220, the V-pit generation layer 230, the active layer 250, and the second conductivity type semiconductor layer 240 of the light emitting diode 200 are identical to the substrate 110, the first conductivity type semiconductor layer 120, the V-pit generation layer 130, the active layer 150, and the second conductivity type semiconductor layer 140 described with reference to FIG. 1, detailed descriptions thereof will be omitted to avoid redundancy.

The stress relief layer 260 is similar to the stress relief layer 160 described with reference to FIG. 1. The stress relief layer 260 may have a structure in which material layers having different energy band gaps are alternately and repeatedly stacked, and these material layers may form a plurality of pairs. For example, the stress relief layer 260 may have a structure in which a first layer having a smaller energy band gap and a second layer having a larger energy band gap are alternately stacked. Furthermore, the stress relief layer 260 may be a superlattice layer. An average lattice constant of the stress relief layer 260 is greater than a lattice constant of the V-pit generation layer 230 or the first conductivity type semiconductor layer 220, and is smaller than an average lattice constant of the active layer 250. In particular, the first layer of the stress relief layer 260 may include a material layer containing In, and a content of In in the first layer may be smaller than that of In contained in a well layer of the active layer 250.

The first and second gap layers 257 and 267 may be nitride semiconductor layers of a same composition, and may have a same composition as, for example, a barrier layer in the active layer 250 or at least one layer (e.g., the second layer) in the stress relief layer 260. The first and second gap layers 257 and 267 may be formed of a material layer having a wider band gap than that of the well layer in the active layer 250.

Meanwhile, the first gap layer 257 and the second gap layer 267 may have a same composition, without being limited thereto. In an exemplary embodiment, when the first gap layer 257 has a composition different from that of the second gap layer 267, a lattice constant of the first gap layer 257 may be greater than that of the second gap layer 267. Accordingly, a stress applied to the active layer 250 may be reduced.

The intermediate layer 270 may be formed of a nitride semiconductor layer having a lattice constant greater than those of the first and second gap layers 257 and 267. In particular, the intermediate layer 270 may be formed of a nitride semiconductor layer including In, for example, InGaN or AlInGaN.

A content of In contained in the intermediate layer 270 may be less than that of In contained in the well layer in the active layer 250, and may be less than that of In contained in the second layer in the stress relief layer 260. Furthermore, the content of In of the intermediate layer 270 may be closer to that of In of the second layer in the stress relief layer 260 than that of In contained in the well layer in the active layer 250. By disposing the intermediate layer 270, the stress applied to the active layer 250 may be further relieved, and a mobility of holes may be controlled by adjusting the content of In in the intermediate layer 270.

Meanwhile, although not illustrated, a nitride semiconductor layer containing Al, for example, a capping layer, may be disposed on the intermediate layer 270 with the intermediate layer 270 interposed therebetween. The capping layer may prevent dissociation of In in the intermediate layer 260.

According to the illustrated exemplary embodiment, by disposing the intermediate layer 270 and the gap layers 257 and 267 between the stress relief layer 260 and the active layer 250, the stress applied to the active layer 250 may be further relieved, and thus, it is possible to improve a crystal quality of the active layer 250, and alleviate droop.

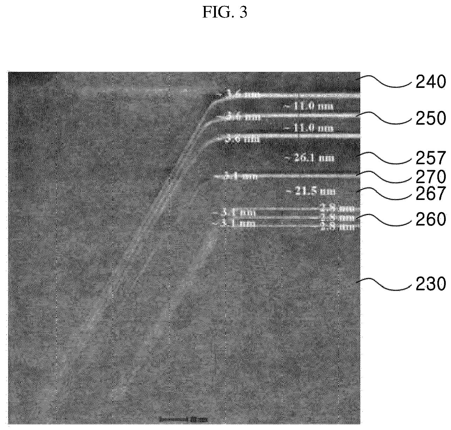

FIG. 3 is a TEM image of a region A of FIG. 2.

Referring to FIG. 3, the stress relief layer 260 has a structure in which the first layer having a thickness of about 2.8 nm and the second layer having a thickness of about 3.1 nm are alternately stacked. The first layer may have a thickness of 5 nm or less, further may have a thickness of 3 nm or less, and may have a thickness of 2 nm or more. The second layer may have a thickness of 5 nm or less, further may have a thickness of 4 nm or less, and may have a thickness of 2 nm or more, furthermore, 3 nm or more. The first layer and the second layer may have, for example, the thicknesses within a range of 2.5 nm to 3.5 nm.

Meanwhile, the intermediate layer 270 may have a thickness of about 5 nm or less, further may have 4 nm or less, and may have a thickness of 2 nm or more, furthermore, 3 nm or more. In addition, the first gap layer 257 and the second gap layer 267 may have thicknesses of, for example, about 20 nm or more, and 30 nm or less. The first and second gap layers are relatively thick, and may have thicknesses of 5 times or more, and further, 8 times or more of a thickness of the intermediate layer 270.

The active layer 250 has a structure in which a well layer and a barrier layer are alternately stacked, and the well layer may have a thickness of generally 5 nm or less, further may have 4 nm or less, and may have a thickness of 2 nm or more, furthermore, 3 nm or more. Meanwhile, the barrier layer may have a thickness of 5 nm or more, further may have 10 nm or more, and may have a thickness of 20 nm or less, furthermore, 15 nm or less. The thickness of the barrier layer may be smaller than that of the first or second gap layers 257 or 267. Meanwhile, the thickness of each layer of the active layer 250 may be greater than that of each of the first and second layers in the stress relief layer 260.

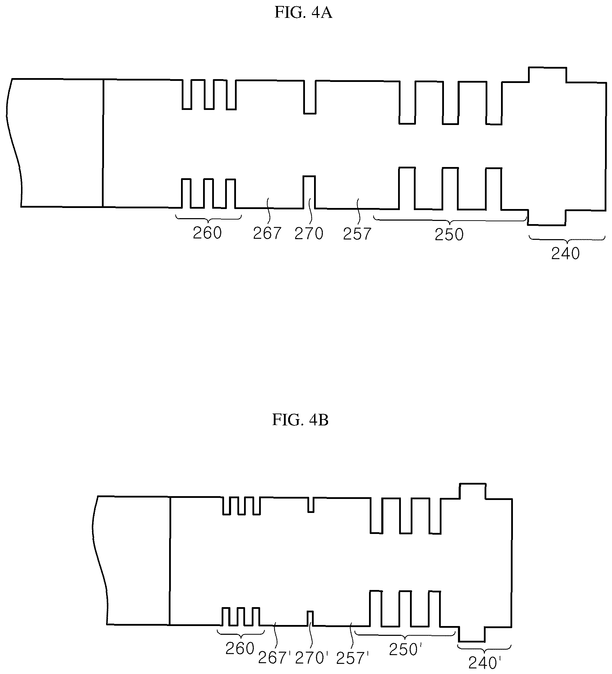

FIG. 4A and FIG. 4B are band diagrams of a stacked structure in L1 and L2 directions of FIG. 2, respectively.

FIG. 4A shows an energy band gap of each layer grown in a growth direction of a c-plane, and FIG. 4B shows an energy band gap of each layer grown on an inclined surface of the V-pit. A thickness of each layer grown on the v-pits is smaller than that of each layer grown on the c-plane.

Referring to FIG. 4A and FIG. 4B, the first conductivity type nitride semiconductor layer 220, the V-pit generation layer 230, the stress relief layer 260, the intermediate layer 270, and the first and second gap layers 257 and 267, the active layer 250, and the second conductivity type nitride semiconductor layer 240 are stacked in this order. An energy band gap of the first layer in the stress relief layer 260 is greater than that of the intermediate layer 270, and that of the well layer in the active layer 250, and an energy band gap of the intermediate layer 270 has a value between an energy band gap of the well layer of the active layer 250 and an energy band gap of the first layer of the stress relief layer 260. The energy band gap of the intermediate layer 270 may be closer to the energy band gap of the first layer than the energy band gap of the well layer.

Meanwhile, as schematically shown in FIG. 4A and FIG. 4B, the band gap energies of the first layer, the intermediate layer 270, and the well layer formed in the V-pit have values greater than the band gap energies of the first layer, the intermediate layer 270, and the well layer grown on the c-plane, respectively.

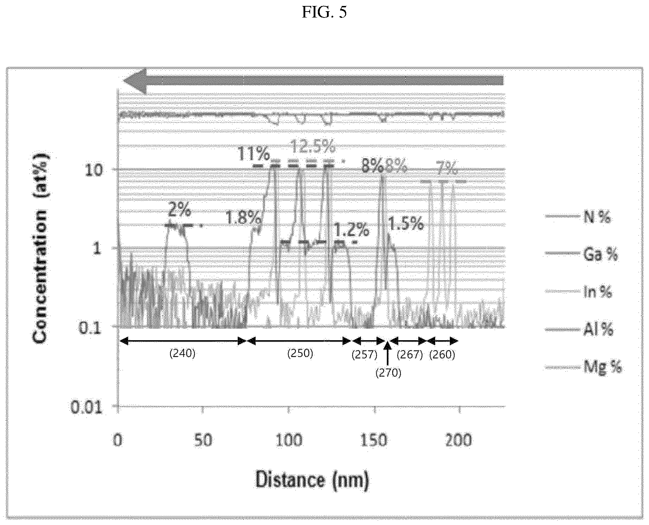

FIG. 5 is an atom probe tomography (APT) graph of a layered structure in the L1 direction of FIG. 2. In the graph, atomic percent of In and Al is expressed numerically, and actual composition ratios of In and Al in the nitride semiconductor layer are twice this value.

Referring to FIG. 5, it is observed that the content of In of the first layer containing In in the stress relief layer is about 7%, the content of In of the intermediate layer is about 8%, and the content of In of the well layer in the active layer is about 12.5%. That is, it can be seen that the content of In increases in an order of the stress relief layer, the intermediate layer, and the active layer, and the content of In in the intermediate layer is closer to that of In of the first layer in the stress relief layer than that of In in the well layer in the active layer.

In addition, the intermediate layer 270 may include AlInGaN, and the second gap layer 267 may include AlGaN adjacent to the intermediate layer 270. In addition, the first gap layer 257 may include another AlGaN layer facing the AlGaN with respect to the intermediate layer 270 and adjacent to the intermediate layer 270. The AlGaN layer of the first gap layer 257 is disposed between the barrier layer of the active layer and an In-containing layer of the intermediate layer 270, and thus, it may function to lower a moving speed of electrons before entering the active layer 250, thereby being more effective in alleviating droop.

Referring to FIG. 5, a content of Al of the barrier layer in the active layer may be decreased in composition as it approaches the second conductivity type nitride semiconductor layer 240 from the first conductivity type nitride semiconductor layer 220. Preferably, the content of Al may be gradually reduced. Accordingly, strain formed inside the active layer may be relieved, and an influence of a change in an amount of currents applied may be reduced, thereby preventing the decrease in external quantum efficiency due to the change in the amount of current, even when a light emitting device has a plurality of emission peaks.

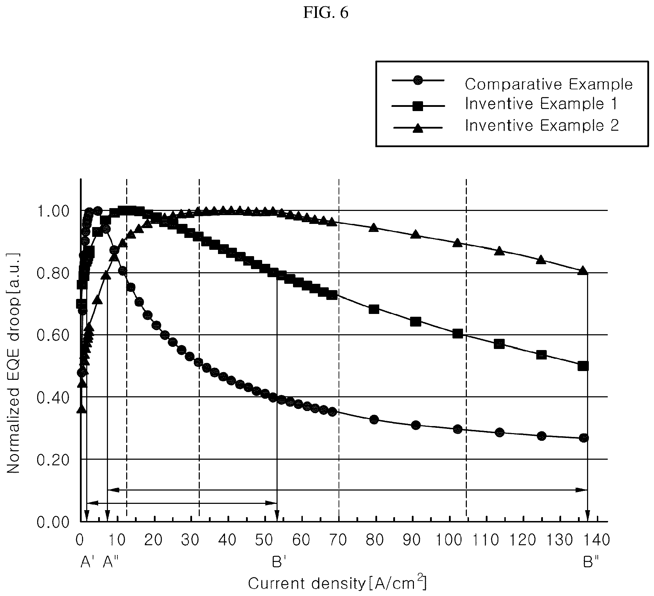

FIG. 6 is a graph showing external quantum efficiency droops (EQE droop) of Comparative Example, Inventive Examples 1 and 2. An active layer was grown on a V-pit generation layer without a stress relief layer In the Comparative Example, a stress relief layer and a gap layer were added between a V-pit generation layer and an active layer in the Inventive Example 1, like the light emitting diode 100 described with reference to FIG. 1, and an intermediate layer and first and second gap layers were added between a stress relief layer and an active layer in addition to the elements in the Inventive Example 1 in the Inventive Example 2, like the light emitting diode 200 described with reference to FIG. 2.

Referring to FIG. 6, in a light emitting diode of the Comparative Example, it can be seen that an external quantum efficiency rapidly increases and decreases as current densities increase. The light emitting diode of the Comparative Example exhibits an external quantum efficiency of 80% or more compared to a maximum external quantum efficiency within a range of 0 to 10 A/cm², exhibits an external quantum efficiency of less than 80% at a current density of 10 A/cm² or more, and exhibits an external quantum efficiency of less than 60% at a current density of 25 mA/cm² or more. In a case of the light emitting diode of the Comparative Example, a current density range showing the external quantum efficiency of 80% or more compared to the maximum external quantum efficiency is less than 10 A/cm². The external quantum efficiency of the light emitting diode of the Comparative Example decreased to 30% or less compared to the maximum external quantum efficiency under the current density of 100 A/cm².

Meanwhile, in a light emitting diode of the Inventive Example 1, compared with the light emitting diode of the Comparative Example, an external quantum efficiency of white light increased relatively gently, and also decreased relatively slowly. In a case of the light emitting diode of the Inventive Example 1, the light emitting diode exhibited an external quantum efficiency of 80% or more for a maximum external quantum efficiency up to a current density of 50 A/cm², and maintained an external quantum efficiency of 60% compared to the maximum external quantum efficiency even up to a current density of 100 A/cm². A current density range maintaining 80% of the maximum external quantum efficiency in the light emitting diode of the Inventive Example 1 is about 50 A/cm².

It can be seen that an external quantum efficiency increases and decreases more gently in a light emitting diode of the Inventive Example 2 than the light emitting diode of the Inventive Example 1. In a case of the light emitting diode of the Inventive Example 2, an external quantum efficiency of 80% compared to a maximum external quantum efficiency was maintained even up to a current density of 135 A/cm². A current density range maintaining 80% of the maximum external quantum efficiency in the light emitting diode of the Inventive Example 2 is 100 A/cm² or more, and further, about 120 A/cm² or more.

In addition, in the Comparative Example, a current density range having the EQE of 80-100% efficiency compared to the maximum EQE is 1 A/cm² (A) ~ 11 A/cm² (B), which corresponds to a current density range of (B)-(A) = Δ10 A/cm², but in the Inventive Example 1, a current density range having the EQE of 80-100% efficiency compared to the maximum EQE is 3 A/cm² (A') ~ 53 A/cm² (B'), which corresponds to a current density range of about (B')-(A') = Δ50 A/cm². Also in the case of the Inventive Example 2, the light emitting diode has 80-100% efficiency compared to the maximum EQE in a current density range of 7 A/cm² (A") ~ 137 A/cm² (B"), which corresponds to a current density range of (B")-(A") = Δ130 A/cm². That is, in the exemplary embodiments, the current density ranges of Δ are relatively large compared to that of the Comparative Example. As such, according to the exemplary embodiments of the present disclosure, a white light emitting device having the EQE of 80-100% may be implemented in a relatively wide current density range even when the current density is changed. According to the illustrated exemplary embodiments, it is possible to implement a white light emitting device having a current density Δ range of Δ 50-130 A/cm² with the EQE of 80-100%.

In both the Inventive Example 1 and the Inventive Example 2 including the stress relief layer, it can be seen that the decrease in EQE according to the increase in current density was reduced compared to the Comparative Example. That is, as the current density increases at a peak point of the EQE, EQE values gently decrease. Moreover, the light emitting diode of the Inventive Example 2 to which the intermediate layer was added had a smaller decrease in the EQE than the light emitting diode of the Inventive Example 1. It can be seen that a droop is alleviated by inserting the stress relief layer and the intermediate layer. It is considered to be a result of the stress relief layer and the intermediate layer contributing to improving a quality of the active layer. Accordingly, it is understood that the internal quantum efficiency (IQE) of the active layer is increased, and further, a droop caused by a defect in the active layer is alleviated.

In addition, it can be seen that in the Comparative Example, the current density having the maximum EQE is formed between 1 A/cm² and 5 A/cm², but in the exemplary embodiment, a point with the maximum EQE is formed in a range of current density 10 A/cm² to 50A/cm².

In the light emitting diodes according to the illustrated exemplary embodiment, a color of emitted mixed light may be changed depending on a current density. For example, as the current density increases, light emitted from the light emitting diode may be changed from warm white light to cool white light. The light emitting diode according to the illustrated exemplary embodiment may be operated under various current densities, and in particular, since it exhibits high external quantum efficiency in a wide current density range, light of various colors may be produced by changing the current densities.

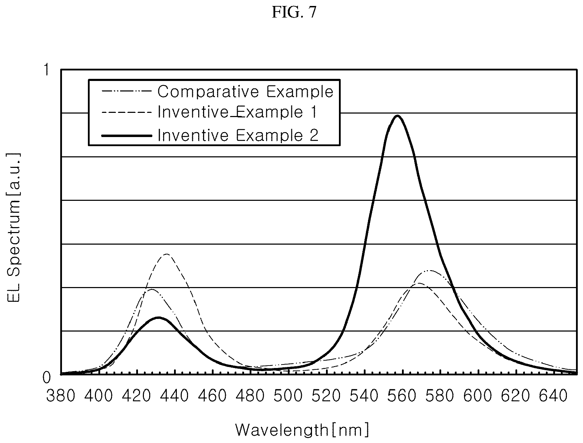

FIG. 7 is a graph showing electroluminescence (EL) spectra of Comparative Example, Inventive Examples 1 and 2.

Referring to FIG. 7, all of the light emitting diodes of the Comparative Example, the Inventive Example 1, and the Inventive Example 2 have a plurality of emission peaks. A spectrum in a longer wavelength region represents light emitted from the well layer grown on the flat surface of the V-pit generation layer, i.e., the well layer of the first region, and a spectrum in the shorter wavelength region represents light emitted from the well layer in the V-pit, i.e. the well layer of the second region. The well layer of the first region may have a peak wavelength in a range of about 500 nm to 640 nm depending on a composition of the well layer, and the well layer of the second region may have a peak wavelength in a range of about 400 nm to 500 nm.

It can be seen that a light emission intensity of the shorter wavelength region is increased by including the stress relief layer in the case of the Inventive Example 1 compared to the Comparative Example. By employing the stress relief layer, a film quality of an inclined surface of the V-pit was improved, and thus, a radiation efficiency of light of the shorter wavelength was improved. Meanwhile, in the Inventive Example 2, an intensity of integration of the emission spectrum in the EL graph is a highest compared to those of the Comparative Example and the Inventive Example 1, and in particular, the peak intensity of light of the longer wavelength emitted from the well layer of the first region formed along the flat surface was about 5.2 times or more than that of light of the shorter wavelength emitted from the well layer of the second region. It is understood that this is because a crystalline quality of the well layer of the first region is improved by employing the stress relief layer, the intermediate layer, and the first and second gap layers, thereby increasing radiative recombination.

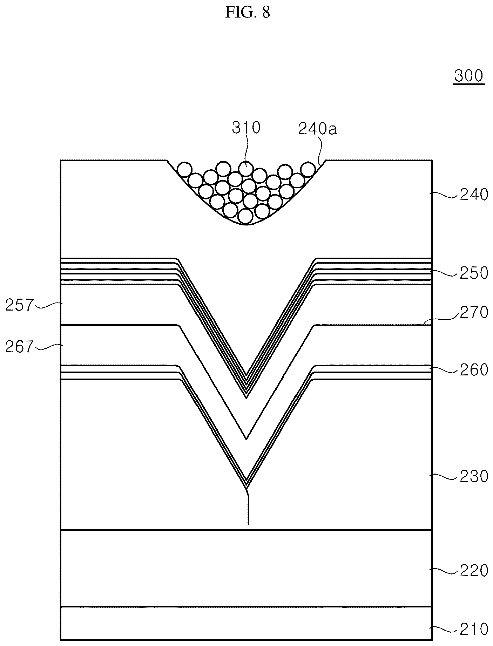

FIG. 8 is a schematic cross-sectional view illustrating a light emitting diode 300 according to another exemplary embodiment of the present disclosure.

Referring to FIG. 8, the light emitting diode 300 according to the illustrated exemplary embodiment is substantially similar to the light emitting diode described with reference to FIG. 2, except that it further includes a wavelength conversion material 310.

As described above, the second conductivity type nitride semiconductor layer 240 may have the concave groove 240a on the upper surface thereof. The concave groove 240a may be disposed over the V-pit. Although FIG. 8 shows one V-pit and the concave groove 240a, a plurality of V-pits may be formed in the light emitting diode 300, with concave grooves 240a respectively disposed on each V-pit.

The wavelength conversion material 310 may be disposed inside the concave groove 240a. For example, after the wavelength conversion material 310 or a medium including the wavelength conversion material 310 is applied on the second conductivity type nitride semiconductor layer 240, a wavelength conversion material 310 filling the concave groove 240a may be formed by removing the wavelength conversion material 310 on the surface of the second conductivity type nitride semiconductor layer 240.

The wavelength conversion material 310 may be, for example, a red-based phosphor or a red-based quantum dot, and may emit light in a range of 500 nm to 700 nm by light generated in the active layer 250 of the light emitting diode 300, for example. Accordingly, color rendering index of the light emitting diode 300 may be improved.

The second conductivity type nitride semiconductor layer 240 may be thickly formed to fill all the V-pits without forming the concave grooves 240a, but in this case, the second conductivity type nitride semiconductor layer 240 is considerably thick, and thus, it may not only reduce the radiation efficiency, but it may also cause internal strain. An Internal strain may increase droop again. Meanwhile, by forming the second conductivity type nitride semiconductor layer 240 relatively thin to form the concave grooves 240a on the surface, and disposing the wavelength conversion material 310 in the concave grooves 240a, it is possible to improve the radiation efficiency of the light emitting diode 300 and further improve color rendering index of light emitted from the light emitting diode 300.

In particular, a size of an inlet of the concave groove 240a may be 200 nm or more, further 300 nm or more, and since quantum dots are generally 5 nm or more in size, a plurality of quantum dots may be disposed in the concave groove 240a. The quantum dots may include materials such as, for example, CdSe,InP, or the like.

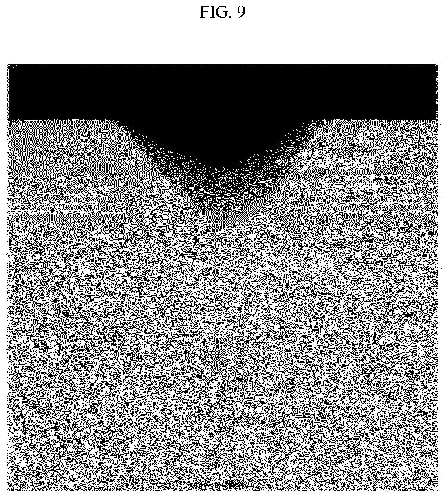

FIG. 9 is a TEM image showing an example of a shape of the surface groove of the light emitting diode.

Referring to FIG. 9, a depth and an inlet of the V-pit have a size of about 300 nm or more. Accordingly, a phosphor or quantum dot having a relatively small size may be disposed in the concave groove 240a. In particular, since the size of the quantum dot is sufficiently smaller than 300 nm, the plurality of quantum dots may be disposed in the concave groove 240a. For example, after the surface of the second conductivity type nitride semiconductor layer 240 is covered with the wavelength conversion material using spin coating or inkjet printing, the wavelength conversion material 310 filling the concave groove 240a may be formed by removing the wavelength conversion material such that the surface of the second conductivity type nitride semiconductor layer 240 is exposed. As another example, squeeze printing may be used.

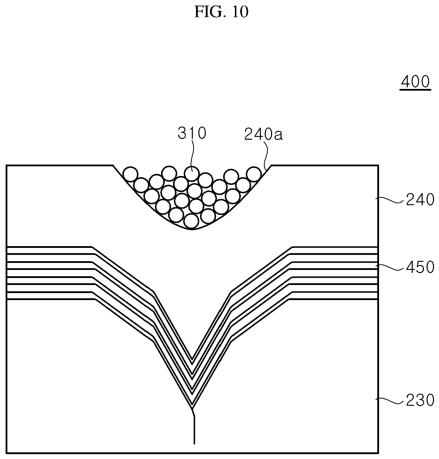

In the illustrated exemplary embodiment, it is described that the wavelength conversion material 310 is additionally formed in the light emitting diode 200 of FIG. 2, without being limited thereto, but the wavelength conversion material 310 may be added to the light emitting diode 100 of FIG. 1. Furthermore, a wavelength conversion material may be added to a light emitting diode without a stress relief layer. Also, although in the illustrated exemplary embodiment, the V-pit is shown as having a single inclined surface, the V-pit may have a plurality of inclined surfaces. This will be described with reference to FIG. 10.

FIG. 10 is a schematic cross-sectional view illustrating a light emitting diode 400 according to another exemplary embodiment of the present disclosure.

Referring to FIG. 10, the light emitting diode 400 according to the illustrated exemplary embodiment is substantially similar to the light emitting diode 300 described with reference to FIG. 8, except that a shape of the V-pit is different. That is, the V-pit formed in the V-pit generation layer 230 have multi-stage inclined surfaces. An active layer 450 may include a well layer in a first region formed on a flat surface of the V-pit generation layer 230, and may include well layers formed by being divided into a plurality of regions in the V-pit. Well layers formed on different inclined surfaces in the V-pit may emit light of different wavelengths from one another. For example, a well layer formed on an inclined surface with a largeer slope contains less In, and thus, emits light of a relatively shorter wavelength. Accordingly, light of various colors may be emitted, thereby improving CRI.

Although not illustrated, light emitting devices may be mounted in a housing after electrodes for electrical connection are formed. A light transmissive material may be disposed on the upper surface of the light emitting device mounted in the housing, and the light transmissive material may cover only an upper surface of the light emitting device or may be formed to cover both the upper surface and side surfaces. Since white light is emitted from the light emitting device, the light transmissive material may not include a wavelength conversion material, but may include a wavelength conversion material so as to implement a desired CRI. Alternatively, a light diffuser or a light reflective material may be included in the light transmissive material for uniform diffusion of light. These materials include Ca, TiO₂, SiO₂, or the like may be used.

While particular embodiments and aspects of the present disclosure have been illustrated and described herein, various other changes and modifications can be made without departing from the spirit and scope of the disclosure. Moreover, although various aspects have been described herein, such aspects need not be utilized in combination. In addition, elements described in an embodiment may be applied to other embodiments without departing from the spirit of the present disclosure. Accordingly, it is therefore intended that the appended claims cover all such changes and modifications that are within the scope of the embodiments shown and described herein.

It should be understood that these embodiments are merely exemplary and are not intended to limit the scope of this disclosure.

## Claims

1. A light emitting diode, comprising:
a first conductivity type nitride semiconductor layer;
a V-pit generation layer disposed on the first conductivity type nitride semiconductor layer and having V-pits;
an active layer disposed on the V-pit generation layer;
a stress relief layer disposed between the V-pit generation layer and the active layer; and
a second conductivity type nitride semiconductor layer disposed on the active layer, wherein:
the stress relief layer and the active layer are formed in the V-pit, as well as on a flat surface of the V-pit generation layer, and
the active layer emits light of a multi-band spectrum.

2. The light emitting diode of claim 1,
wherein the stress relief layer is a superlattice layer.

3. The light emitting diode of claim 1,
wherein the stress relief layer has a structure where first and second layers are alternately stacked, an energy band gap of the first layer is smaller than that of the second layer, and a lattice constant of the first layer is greater than that of the V-pit generation layer and smaller than that of a well layer of the active layer.

4. The light emitting diode of claim 1, further comprising:
a gap layer between the stress relief layer and the active layer,
wherein the gap has a lattice constant smaller than an average lattice constant of the stress relief layer.

5. The light emitting diode of claim 1, further comprising:
an intermediate layer disposed between the stress relief layer and the active layer;
a first gap layer disposed between the intermediate layer and the active layer; and
a second gap layer disposed between the intermediate layer and the stress relief layer, wherein:
the first and second gap layers have lattice constants smaller than an average lattice constant of the stress relief layer, and
the intermediate layer has a lattice constant greater than the average lattice constant of the stress relief layer.

6. The light emitting diode of claim 5,
wherein the stress relief layer has a structure where first and second layers are alternately stacked, an energy band gap of the first layer is smaller than that of the second layer, and a lattice constant of the first layer is greater than that of the V-pit generation layer and smaller than that of a well layer of the active layer.

7. The light emitting diode of claim 6, wherein:
the first layer of the stress relief layer, the intermediate layer, and the well layer of the active layer are nitride semiconductor layers containing In, and
the first layer contains a least In, and the well layer of the active layer contains a most In among the first layer of the stress relief layer, the intermediate layer, and the well layers of the active layer

8. The light emitting diode of claim 7,
wherein a content of In contained in the intermediate layer is closer to a content of In contained in the first layer than a content of In contained in the well layer of the active layer.

9. The light emitting diode of claim 1, further comprising:
a wavelength conversion material disposed on the second conductivity type nitride semiconductor layer, wherein:
the second conductivity type nitride semiconductor layer has a concave groove on a surface thereof, and
the wavelength conversion material is disposed in the concave groove.

10. The light emitting diode of claim 9,
wherein the wavelength conversion material includes quantum dots emitting red light.

11. A light emitting diode maintaining an external quantum efficiency of 80% or more compared to a maximum external quantum efficiency over a current density range of 50 A/cm² or more.

12. The light emitting diode of claim 11, comprising:
a substrate; and
a nitride semiconductor layer grown on the substrate,
the substrate has a c-growth plane, and the nitride semiconductor layer is grown on the c-growth plane of the substrate.

13. The light emitting diode of claim 11,
wherein the light emitting diode maintains an external quantum efficiency of 80% or more compared to a maximum external quantum efficiency over a current density range of 100 A/cm² or more.

14. The light emitting diode of claim 11,
wherein the light emitting diode maintains an external quantum efficiency of 80% or more compared to a maximum external quantum efficiency over a current density range of 120 A/cm² or more.

15. The light emitting diode of claim 11,
wherein the light emitting diode maintains an external quantum efficiency of 60% or more compared to a maximum external quantum efficiency over a current density range of 100 A/cm² or more.

16. The light emitting diode of claim 11,
wherein the light emitting diode emits white light having a different color temperature depending on a current density, and emits white light having a higher color temperature at a higher current density.

17. The light emitting diode of claim 11, comprising:
a first conductivity type nitride semiconductor layer;
a V-pit generation layer disposed on the first conductivity type nitride semiconductor layer and having V-pits;
an active layer disposed on the V-pit generation layer;
a stress relief layer disposed between the V-pit generation layer and the active layer; and
a second conductivity type nitride semiconductor layer disposed on the active layer, wherein the active layer emits light of a multi-band spectrum.

18. The light emitting diode of claim 17, further comprising:
an intermediate layer disposed between the stress relief layer and the active layer;
a first gap layer disposed between the intermediate layer and the active layer; and
a second gap layer disposed between the intermediate layer and the stress relief layer,
wherein the intermediate layer is a nitride semiconductor layer having a lattice constant smaller than an average lattice constant of the stress relief layer.

19. The light emitting diode of claim 17, further comprising:
a substrate, wherein:
the substrate has a c- growth plane, and
the first conductivity type nitride semiconductor layer is grown on the c-growth plane of the substrate.

20. The light emitting diode of claim 17, further comprising:
a wavelength conversion material disposed on the second conductivity type nitride semiconductor layer, wherein:
the second conductivity type nitride semiconductor layer has a concave groove on a surface thereof, and
the wavelength conversion material is disposed in the concave groove.
